# EUROPEAN PATENT APPLICATION

(11) **EP 1 261 043 A2**
(43) Date of publication of application: **27.11.2002**
(21) Application number: 02425330.4
(22) Date of filing: 23.05.2002
(51) Int. Cl.: H01L 51/20

(54) **Precursory system of water-absorbing devices for electroluminescent screens, production process and method of use thereof**

(30) Priority: 23.05.2001 IT MI20011092
(71) Applicant: SAES GETTERS S.p.A., 20020 Lainate (Milano) (IT)
(72) Inventor: Tominetti, Stefano, 20151 Milano MI (IT); Ferrario, Bruno, 20027 Rescaldina MI (IT); della Porta, Anna, 20121 Milano MI (IT); della Porta, Massimo, 20123 Milano MI (IT)
(74) Representative: Adorno, Silvano

(57) **Abstract**

A precursory system (10, 20) is described for water-absorbing devices (61) to be used in electroluminescent organic screens (60), having a very reduced thickness with respect to similar known systems. Also described are some processes for the production of the inventive system and some methods for the use thereof in the production of electroluminescent organic screens.

## Description

The present invention relates to a precursory system of water-absorbing devices for electroluminescent organic screens, to the process for its production and to the method of using the system in the production of said screens; in particular, the invention refers to a precursory system of absorbing devices having a very thin thickness.

The electroluminescent organic screens are in development stage for the production of flat screens having very reduced thickness and weight. The main foreseen applications in a short term are in the form of bright screens for mobile telephones, stereo appliances, car fascias and the like, but it is not to be excluded the production of great screens able to reproduce moving images to be used for example as screens of computers or television sets.

These screens are based on the use of diode devices known in the field as "Organic Light Emitting Diode" or its acronym OLED used to define the very screens.

In short, an OLED screen is formed by a first transparent planar support (of glass or plastics); a second not necessarily transparent support that may be made of glass, metal or plastics and substantially planar and parallel to the first support and secured to the perimeter of the latter, so as to form a closed space; and a structure active in forming the image in said space. The active structure is in turn formed by a first set of transparent linear and mutually parallel electrodes, deposited on the first support; a multilayer of different electroluminescent organic materials, comprising at least one layer of electron-conductive material and one layer of an electronic vacancies-(also defined in the field as "holes")-conductive material deposited on the first set of electrodes; a second set of linear and reciprocally parallel electrodes that are orthogonally oriented with respect to those of the first set and in contact with the opposed side of the multilayer of organic materials, so that the latter is comprised between both sets of electrodes; the electrodes of this second set comprise, in direct contact with the organic material, a layer of a greatly electropositive material, such as barium, calcium or lithium fluoride, having the function of facilitating the injection of electrons in said material. For a more detailed description of the structure and operation of OLED screens one can refer for instance to patent applications EP-A-845924, EP-A-949696, JP-A-9-078058 and patent US 6,013,384.

The main problem encountered with these screens is the quick deterioration of the light-emitting properties following the entrance of some gases, such as water, mainly penetrating by permeation through the epoxy resins generally used to form the perimetric heat seal of both supports, or by release due to these very resins; other gases which seem to damage the OLED are the oxidizing gases such as oxygen and carbon dioxide. The life of these devices comes down from thousands or tens of thousands of hours in the absence of oxidizing gases (as it was verified by tests in suitable chambers) to few hours when exposed to the atmosphere. Even if the functional deterioration mechanisms of the OLEDs have not yet been totally explained, it is likely that this phenomenon is partially ascribable to addition reactions of the molecules of these gases with the unsaturated bonds of the organic component, and with the electropositive materials present in the second set of electrodes.

Possible solutions of the problem are proposed in patent US 5,804,917 and international publication WO 99/35681 which describe OLED screens by citing also the possible usage of moisture-absorbing materials: in these documents however this latter aspect is approached in a faint way, by simply showing the recourse to a getter applied to the second support of the OLED, without any specification of the nature of the getter material neither giving useful suggestions of the construction details of an OLED containing said getter material.

The international patent application WO 98/59356 describes the use of a getter material arranged within the OLED and secured on the second support. This patent shows generally the possibility of using materials such as Ba, Li, Ca, BaO or the like, but does not explain how to deposit in a stable manner these materials on the second support, neither copes with the problem of alterations, deformations or particle loss of these layers as a consequence of water absorption; lost particles from these materials following a water absorption may mechanically or chemically damage the electrodes of the second set, thus impairing the OLED functionality.

European patent application EP-A-776147 describes the use within the OLEDs of solid chemical desiccants, such as for instance CaO and BaO that inevitably absorb water and remain solid even after this absorption. However, in this case too it is not described how to fix the chemical desiccant on the second support; the gluing of the desiccant (being generally in powder form) on said support is described, but the problems of a possible loss of particles from this configuration are not coped with, in the case of an incomplete covering of the whole powder with the glue, nor on the contrary the (nearly) inactivation of the desiccant agent in the case that such a covering becomes complete.

Another demand of the OLED producers, that becomes difficult to be satisfied by the methods described in the previously named patents, is the thickness limitation of the gas-absorbing system, which is desirable in view of the overall thickness reduction of the OLED.

The object of the present invention is to provide a precursor system of water-absorbing devices for electroluminescent organic screens, and in particular of thin devices, as well as to provide the process for the production thereof and the method of use in the production of screens.

This object is achieved according to the present invention, that in a first aspect refers to a precursory system of water-absorbing devices comprising:
- a sheet made of a metallic material or a polymer/metal multilayer;
- one or more deposits of a water-absorbing material selected among alkali metals and alkali-earth metals in central portion of a face of the sheet; and
- a protective film of the water-absorbing material, formed with a metallic material or a polymer/metal multilayer and secured to the sheet on the same face on which the deposit of absorbing material is present and in a perimetric zone of the sheet that is free from said deposit.

The invention will be described below with reference to the drawings in which:
- Figure 1 shows a cut-out view of a first precursory system of the invention and Figure 1a shows a sectional view of a portion of edge of the system of Fig, 1;
- Figure 2 shows a cut-out view of a second possible precursory system of the invention;
- Figure 3 shows the main operations of the production process of system in figure 1;
- Figure 4 shows an operation of a possible production process of the system in figure 2;
- Figure 5 shows a schematical section of a screen of OLED type; and
- Figure 6 shows the section of an OLED screen wherein there is used a moisture-absorbing device derived from a system according to the invention.

The devices derived from the absorbing system of the invention are mainly addressed to the absorption of water that was identified as the most dangerous gas for the working of OLEDs; these devices are however also capable of absorbing oxygen and, following the absorption of water, carbon dioxide.

The system of the invention comprises essentially three constitutive elements: a water-impermeable supporting sheet, one or more deposits of an alkali or alkali-earth metal on a face of the sheet and a gas-impermeable film secured along the perimeter of the sheet on the same face of metallic deposit so as to temporarily protect the absorbing metal from the contact with external gases up to the moment of its introduction in the OLED; immediately prior to the introduction into the OLED, the protective film is removed, thus obtaining an absorbing device wherein the active metal is exposed to the inner atmosphere of the OLED.

To form the sheet it is possible to use the metals or multilayers made with at least a double metal-plastics layer. Among the metals, it is preferred to use aluminum that can easily be produced in the form of thin sheets, down to few microns. The preferred thicknesses for the sheet, in the case this is made of aluminum, are comprised between about 5 and 50 µm: thicknesses lower than 5 µm are inexpedient, since the production of aluminum sheets having such thicknesses involves the presence in the sheet of minute through holes (denoted in the field as "pin-holes"), whereas thicknesses higher than about 50 µm do increase the thickness of the final absorbing system without providing other advantages; preferred is the use of aluminum sheets with a thickness comprised between about 10 and 25 µm. Alternatively, the supporting sheet may be formed with a polymer/metal multilayer. These multilayers are widely known and used mainly in the field of food packaging and for the production of the envelopes of thermoinsulating jackets filled with inorganic or polymeric powders or polymeric foams; polymer/metal multilayers are described for example in European patent application EP-A-734854, in international application WO 97/36129 and in patent US 4,444,821. A polymer/metal multilayer comprises at least one metallic and one polymeric layers, but more usually it is formed by a thin metal layer comprised between two polymer layers that mechanically support and protect the metal layer; common are also multilayers comprising more than three alternate polymer/metal layers, but for the objects of the invention it is preferable to use sheet containing only two or three layers, to minimize the thickness of the sheet. This thickness will preferably be comprised between about 50 and 100 µm.

The protecting film may be formed with the same materials and thicknesses of the sheet, and preferably of aluminum.

The fixing between sheet and film can be obtained by heat seal when the facing surfaces of these components are made of a plastic materials, for example of polyethylene; in this case, the heat seal takes place by compression between rolls or compression rods heated to temperatures of about 100°C. Alternatively the fixing may be formed by a glue.

The water-absorbing material can be an alkali or alkali-earth metal, preferably calcium, strontium or barium, and is in the form of a deposit with a thickness lower than 10 µm set down on central portion of the same face of sheet to which the protecting film is secured.

Some embodiments of the inventive system are described below.

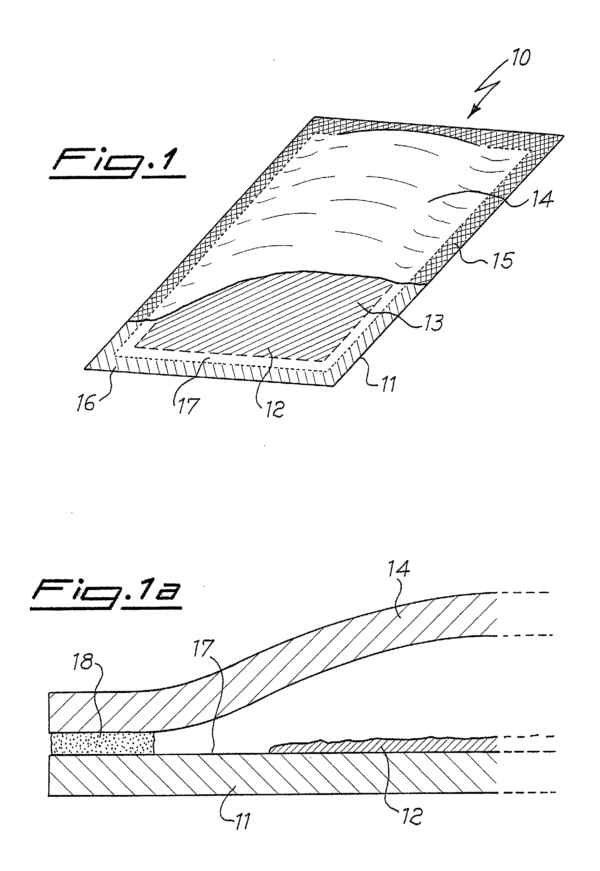

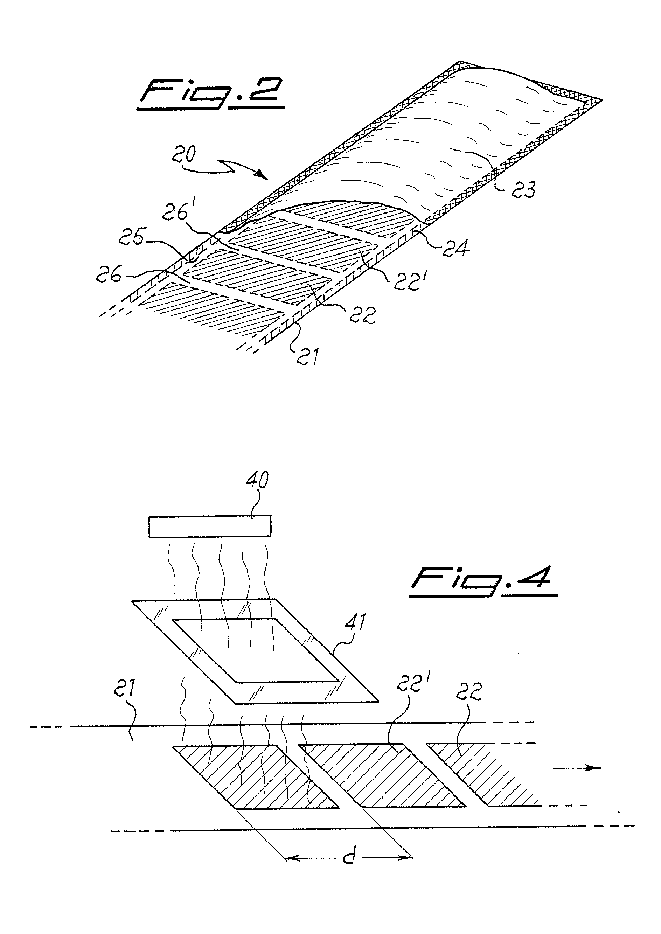

Figure 1 shows a cut-out view of a first possible system 10 of the invention. This system has about the size of OLED screen to which it is committed, and is formed by a sheet 11, in central portion of which a deposited layer 12 of water-absorbing material 13 is present; the system is closed by film 14 joined to sheet 11 with a fixing 15 along the perimetric zone 16 of sheet 11; between zone 16 and deposit 12 there is a free zone 17. Figure 1a represents a magnification of an edge zone of system 10 that points out fixing 15 between sheet 11 and film 14, and free zone 17; the fixing is exemplified in this case by means of a glue 18.

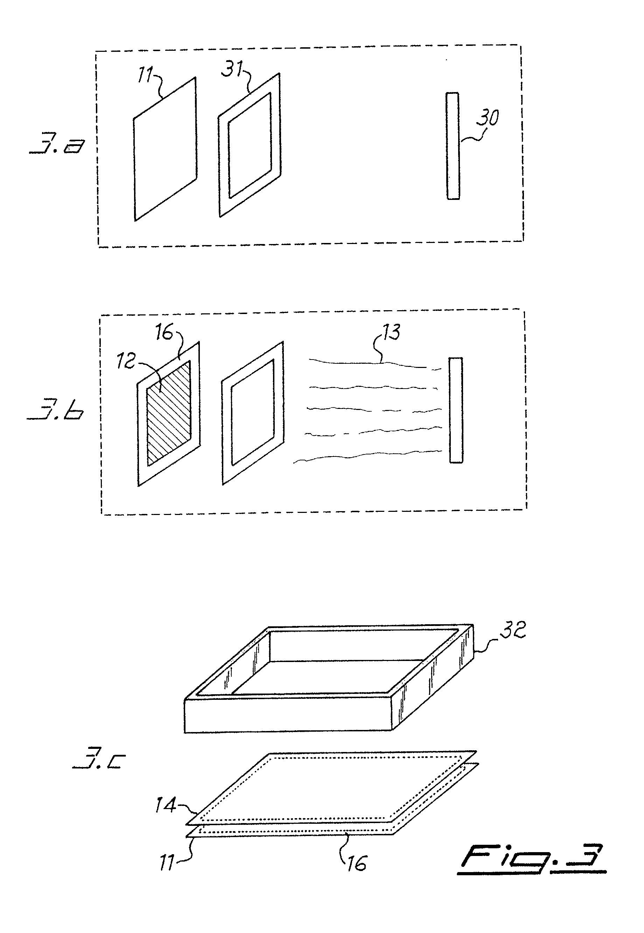

The inventive system may also comprise a plurality of deposits mutually separated by material 13. This embodiment is represented as a cut-out view in figure 2. In this case, system 20 has a size that is a multiple of that of system 10 and of final OLED screen; in particular, the dimensions of final OLED screen are about equal to those of each individual deposit present in system 20. System 20 is formed as a band made by sheet 21 on which several deposits 22, 22',... of material 13 are present; at the perimeter of sheet 21 there is secured film 23 along zone 24 on sheet 21 separated from the deposits by zone 25; deposits 22, 22',... are mutually separated by zones 26, 26',...

In a second aspect, the invention relates to the production process of the precursor system of absorbing devices so far described in its variants. This process comprises he following operations:
- preparing a sheet formed with a metallic material or with a polymer/metal multilayer;
- preparing a film formed with a metallic material or with a polymer/metal multilayer;
- forming by cathodic deposition or evaporation in central portion of a sheet face one or several deposits of a water-absorbing material selected among alkali metals and alkali-earth metals; and
- securing said film to said sheet along their perimeter.

The deposition of the metals can be effected by cathodic deposition (a technique more known in the field as "sputtering") or preferably by evaporation. In the case of sputtering, it is possible to use metal sources in the form of cylindrical cathodes or wires or braids of wires; the latter possibility is described in international patent application WO 97/49109. In the case of evaporation of alkali metals, it is possible to use known evaporative systems, of the type based on metal chromates, described for instance in patents US 2,117,735, US 3,578,834, US 3,579,459, US 3,598,384, US 3,636,302, US 3,663,121, and US 4,233,936. In the case of evaporation of alkali-earth metals, it is possible to use for example the evaporative devices used for the evaporation of calcium, strontium and barium in cathodic tubes, described for instance in patents US 3,225,911, US 3,385,420, US 3,719,433, US 3,816,788, US 3,952,226, US 4,134,041, US 4,214,184 and in international patent application WO 01/01436.

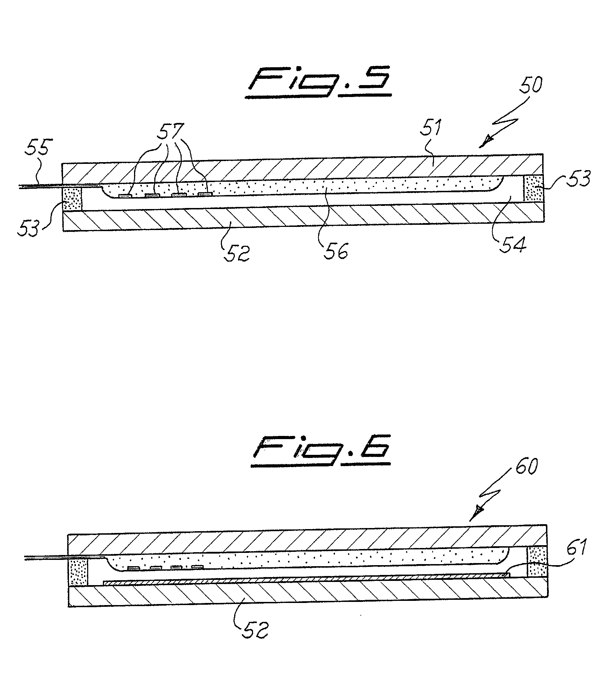

In a first variant of the process, the absorbing system is produced individually, that is, in such a way that the sequence of operations so far described leads to a water-absorbing system containing a single metallic deposit and having dimensions similar to those of the OLED with final destination. The various operations of this variant are represented in figure 3, which illustrates the production of a system of type 10 in figure 1. In operation 3.a sheet 11 is inserted in a deposition chamber (schematized by hatching) wherein a source 30 of the metal to be deposited is present. Between sheet 11 and source 30 there is present an element 31 that serves as a partial masking of the sheet; during operation 3b, wherein the evaporation or cathodic deposition of metal 13 takes place, the presence of element 31 allows to obtain on sheet 11 a deposit 12 of metal that leaves its perimetric zone free, which is the sum of zones 16 and 17 in figure 1. The last operation 3.c lies in securing membrane 14 to sheet 11 along zone 16 thereof: this operation is carried out by compression with an element 32 having a convenient shape, or with two orthogonal couples of pressing rods in the case that fixing 15 is made by gluing, or pressing and heating rods when fixing takes place by heat seal.

In a preferred variant of the inventive process, the sequence of operations so far cited leads to the production of a system from which it is possible to obtain several absorbing systems to be used in OLED screens. In this case the inventive system can be obtained in various ways: a first possibility (not shown in the drawings) is to slide, under a source continually giving out metal 13, a sheet 21 shaped as a band to which a masking element is superimposed, also shaped as a band and provided with holes corresponding to the shape of deposits 22, 22',.... In an alternative embodiment of the process shown in figure 4, deposits 22, 22',..., are obtained in discrete steps; in this case source 40 is activated intermittently, by alternating metal 13 emission phases with rest phases; the band forming sheet 21 is advanced in the arrow-denoted direction by discrete steps having a length "d" in the figure during the rest phases of the source; a still shielding element 41 is interposed between the band and the source ; after each metal deposition stage the band is advanced by the prefixed length, thus obtaining the desired sequence of deposits 22, 22',... mutually separated. The last operation of the producing process of system 20 (not shown in the figure) is the fastening of film 24; in this case the gluings or heat seals at the ends of the band will be again made by means of suitable rods or shapes, while the longitudinal gluings or heat seals will preferably be made by maeans of compression or compression/heating rollers.

In a last aspect, the invention refers to the method for using the water-absorbing devices so far described in OLED screens.

Figure 5 shows in section and in a very schematical way the internal structure of an OLED without any water-absorbing system. OLED 50 is formed of a first transparent support 51 and a second support 52 secured along their perimeter by means of a glue 53, thus defining a closed space 54. On the inner face of first support there are provided, in a sequence, a first set of electrodes 55, a multilayer of electroluminescent organic materials 56, and a second set of electrodes 57.

The method lies in inserting a system of the invention into an OLED production chamber, removing protective film 14 or 24, possibly dividing system 20 in as many devices as are deposits 22, 22',... and inserting into the OLED screen a device derived from a system of type 10 or 20 with the deposit of alkali or alkali-earth metal directed towards the structure formed of the electrodes and electroluminescent organic material.

According to the inventive method, a system of type 10 or 20 is inserted in a chamber under inert atmosphere or under vacuum of the production line of the OLEDs. Immediately prior to the introduction into the OLED, the protective film 14 or 24 is removed by automated means present in the chamber: the removal of the film may take place by stripping it away, mainly when the film is secured to the sheet with glues, or by shearing in any case. In the case of shearing, this is effected along a continuous line comprised in zone 17 in a system of type 10, or in zone 25 in a system of type 20. When using system 20, the shearing will be also effected in the chamber along zones 26, 26',... thus obtaining from system 20 a plurality of devices, each comprising a single deposit 22, 22',.... Finally, as shown in figure 6, the single device 61 obtained from system 10 or 20 is inserted into OLED screen 60, with the metallic deposit directed towards the electroluminescent structure, and preferably in contact with second support 52. Device 61 is preferably adhered to support 52 by means of glues or a biadhesive tape.

## Claims

1. A precursory system (10, 20) of water-absorbing devices (61) for electroluminescent organic screens (50) comprising:
- a sheet (11, 21) made of metallic material or polymer/metal multilayer;
- one or more deposits (12; 22, 22',...) of a water-absorbing material (13) selected among alkali and alkali-earth metals, in the central portion of the sheet face; and
- a protective film (14; 23) for the water-absorbing material, that is formed with a metallic material or with a polymer/metal multilayer and is secured to the sheet on the same face on which the deposit of absorbing material is present and in a perimetric zone (16; 24) of the sheet which is free from said deposit.

2. A system according to claim 1, wherein the sheet is made of aluminum and has a thickness comprised between 5 and 50 µm.

3. A system according to claim 2, wherein said thickness is comprised between 10 and 25 µm.

4. A system according to claim 1, wherein the sheet is made of a polymer/metal multilayer with a thickness comprised between 50 and 100 µm.

5. A system according to claim 1, wherein the deposit of moisture-absorbing material has a thickness lower than 10 µm.

6. A system according to claim 1, wherein said absorbing material is calcium, strontium or barium.

7. A system according to claim 1, wherein said film is made of aluminum and has a thickness comprised between 5 and 50 µm.

8. A system according to claim 7, wherein said thickness is comprised between 10 and 25 µm.

9. A system according to claim 1, wherein said film is made with a polymer/metal multilayer having a thickness comprised between 50 and 100 µm.

10. A system according to claim 1, wherein said sheet and said film are mutually fixed by heat seal or gluing.

11. A production process of a precursor system of water-absorbing devices comprising the following operations:
- preparing a sheet formed with a metallic material or with a polymer/metal multilayer;
- preparing a film formed with a metallic material or with a polymer/metal multilayer;
- forming by cathodic deposition or by evaporation in central portion of a sheet face one or more deposits of water-absorbing material selected among the alkali metals and alkali-earth metals; and
- fixing said film and said sheet along their perimeter.

12. Process according to claim 11, wherein a precursor system (10) of a single moisture-absorbing device is produced.

13. Process according to claim 11, wherein a precursor system (20) of a plurality of moisture-absorbing devices is produced.

14. Method for the use of a system of claim 1 for introducing a moisture-absorbing device (61) in an electroluminescent organic screen (60), comprising the steps of inserting said system in a production chamber of said screen, removing the protective film (14) of the system, and inserting the so obtained device within said screen with the deposit of alkali metal or alkali-earth metal directed towards the structure formed by the electrodes and the electroluminescent organic material.

15. Method for the use of a system of claim 1 for introducing a moisture-absorbing device (61) in an electroluminescent organic screen (60), comprising the steps of inserting said system in a production chamber of said screen, removing the protective film (24) of the system, dividing the system in as many devices as are the deposits of metal (22, 22',...) present therein, and inserting the so obtained device within said screen with the deposit of alkali metal or alkali-earth metal directed towards the structure formed by the electrodes and the electroluminescent organic material.
